# EUROPEAN PATENT APPLICATION

(11) **EP 2 897 161 A1**
(43) Date of publication of application: **22.07.2015**
(21) Application number: 14151283.0
(22) Date of filing: 15.01.2014
(51) Int. Cl.: H01L 21/8258, H01L 21/8238

(54) **Methods for manufacturing a CMOS device**

(71) Applicant: IMEC, 3001 Leuven (BE)
(72) Inventor: Waldron, Niamh, 3001 Leuven (BE); Witters, Liesbeth, 3001 Leuven (BE)
(74) Representative: Bird Goën & Co

(57) **Abstract**

Methods are provided for manufacturing a CMOS device comprising transistor devices of different conductivity types, the respective transistor devices having channel materials which have different lattice constants.

## Description

### Technical field

The present disclosure relates to methods for manufacturing a CMOS device. It relates to a method for combining two different channel materials, both channel materials having different lattice constants and the channel materials respectively being part of transistor devices of different conductivity, on a common silicon substrate.

### Background art

Different semiconductor channel materials are preferred on the same silicon substrate for CMOS high mobility device integration. Typical examples are strained or relaxed Germanium and III-V channel materials.

Hetero-epitaxial growth of semiconductors usually suffers from strain relaxation dislocation formation due to the difference (mismatch) of lattice parameters of the materials involved.

There exists an industrial need for solutions which allow the manufacturing of high mobility CMOS devices using Germanium for PMOS and III-V materials for NMOS together on the same silicon substrate, while achieving low defect levels.

### Summary of the disclosure

It is an aim of the present disclosure to provide methods for manufacturing a CMOS device, the CMOS device comprising transistor devices of different conductivity types, which allows integration of transistor devices which comprise channel materials which have different lattice constants, and whereby these different lattice constants of the respective channel materials are different from the lattice constant of an underlying silicon substrate, on which the transistor devices are formed.

This aim is achieved according to the disclosure with a method showing the technical characteristics of the independent claims.

According to a **first aspect** of the present invention, a method for manufacturing a CMOS device is disclosed, the CMOS device comprising transistor devices of different conductivity types, the respective transistor devices having channel materials which have different lattice constants, comprising:
- providing a silicon substrate;
- providing a strain relaxed buffer layer on the substrate, the strain relaxed buffer layer selected as one of the set of a silicon germanium SRB layer, a combination of a silicon germanium SRB layer and a strained germanium layer, and a III-V semiconductor material SRB layer comprising at least one upper quantum well layer;
- performing a shallow trench isolation process to the strain relaxed buffer layer, comprising patterning the strain relaxed buffer layer into a set of protrusions, for instance extending from the substrate, and providing an isolation material, e.g. silicon oxide in between adjacent protrusions to electrically isolate them from each other, the protrusions and the isolation structures abutting on a common planar surface, the protrusions having a first conductivity type;
- removing an upper portion of at least one protrusion, for instance up until a level within the SRB layer or up until the silicon substrate, thereby leaving a corresponding trench;
- growing a semiconductor material in the trench to thereby form a second type of protrusion, e.g. a protrusion of a second conductivity type; wherein the semiconductor material comprises germanium if the strained relaxed buffer layer is a III-V semiconductor material SRB layer or comprises a III-V semiconductor material wherein the SRB layer is a silicon germanium SRB layer.

According to a **second aspect** of the present invention, a method is disclosed for manufacturing a CMOS device, the CMOS device comprising transistor devices of different conductivity types, the respective transistor devices having channel materials which have different lattice constants, comprising:
- providing a silicon substrate;
- providing a layer stack on the substrate, the layer stack comprising a strain relaxed buffer layer and being selected as one of the set of a silicon germanium SRB layer, a combination of a silicon germanium SRB layer and a strained germanium layer on top, and a III-V semiconductor material SRB layer comprising at least one upper quantum well layer;
- providing a dielectric layer on top of the layer stack;
- providing a semiconductor layer on top of the dielectric layer, the semiconductor layer comprising germanium when the layer stack is a III-V semiconductor SRB layer with one or more III-V quantum well layers on top, or comprising a III-V semiconductor layer if the layer stack is a silicon germanium SRB layer or a silicon germanium SRB layer with a strained germanium layer on top;
- selectively removing the semiconductor layer and the dielectric layer in a first area of the substrate, to thereby expose the layer stack in the first area;
- performing a shallow trench isolation process to the layer stack in the first area, comprising patterning the layer stack into a set of protrusions, for instance extending from the substrate, and providing an isolation material, e.g. a silicon oxide in between adjacent protrusions to electrically isolate them from each other, the protrusions and the isolation structures abutting on an upper common planar surface, the protrusions having a first conductivity type and the protrusions corresponding to channel structures of transistors of a first conductivity type;
- patterning the semiconductor layer in a second area adjacent to the first area, thereby defining channel structures of transistor device of a second conductivity type.

According to a **third aspect** of the present invention, a method for manufacturing a CMOS device is disclosed, the CMOS device comprising transistor devices of different conductivity types, the respective transistor devices having channel materials which have different lattice constants, comprising:
- providing a silicon substrate;
- providing a first dielectric layer on a main surface of the silicon substrate;
- providing a first semiconductor layer, the first semiconductor layer being selected from a set of a germanium layer and a III-V semiconductor material layer stack, on top of the first dielectric layer;
- providing a second dielectric layer on top of the first semiconductor layer;
- providing a second semiconductor layer on top of the second dielectric layer, the second semiconductor layer being the other one of the set of a germanium layer and a III-V semiconductor material layer stack;
- selectively removing the second semiconductor layer and the second dielectric layer in a first area of the substrate, to thereby expose the first semiconductor layer in the first area;
- patterning the exposed first semiconductor layer in the first area, thereby defining channel structures of transistor devices of a first conductivity type;
- patterning the second semiconductor layer in a second area adjacent to the first area, thereby defining channel structures of transistor device of a second conductivity type.

Preferred embodiments are further disclosed in the dependent claims.

### Brief description of the drawings

The disclosure will be further elucidated by means of the following description and the appended figures.
Figure 1 and 2 illustrate process flows according to a first aspect of the present invention.
Figure 3 and 4 illustrate process flows according to a second aspect of the present invention.
Figure 5 and 6 illustrate process flows according to a third aspect of the present invention.

### Detailed description of preferred embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

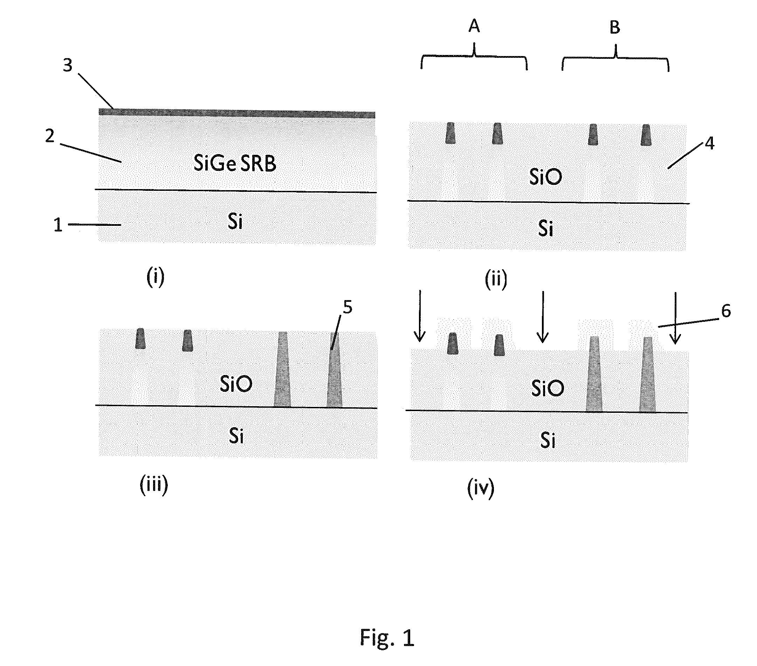

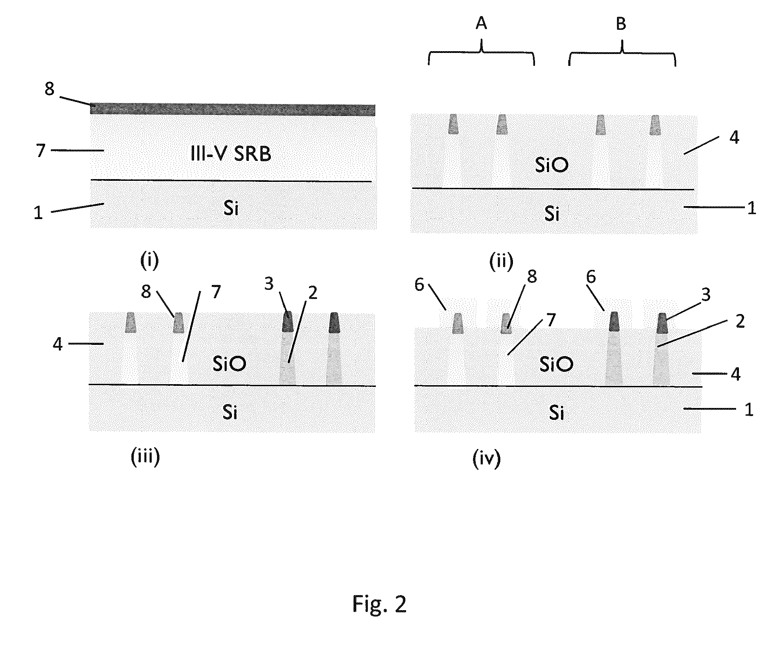

According to a **first aspect** of the present invention, illustrated in Figure 1 and 2, a method for manufacturing a CMOS device is disclosed, the CMOS device comprising transistor devices of different conductivity types, the respective transistor devices having channel materials which have different lattice constants, comprising:
- providing a silicon substrate 1;
- providing a strain relaxed buffer layer on the substrate 1, the strain relaxed buffer layer selected as one of the set of a silicon germanium SRB layer 2, a combination of a silicon germanium SRB layer 2 and a strained germanium layer 3, and a III-V semiconductor material SRB layer 7 comprising at least one upper quantum well layer 8;
- performing a shallow trench isolation process to the strain relaxed buffer layer, comprising patterning the strain relaxed buffer layer into a set of protrusions 2,3 or 7,8, for instance extending from the substrate 1, and providing an isolation material as for instance silicon oxide 4 in between adjacent protrusions to electrically isolate them from each other, the protrusions and the isolation structures 4 abutting on a common planar surface;

- removing an upper portion of at least one protrusion 2,3 or 7,8, for instance up until a level within the SRB layer or up until the silicon substrate 1, thereby leaving a corresponding trench;
- growing a semiconductor material in the trench to thereby form a second type of protrusion, e.g. protrusions of a second conductivity type, 5 or 2,3; wherein the semiconductor material comprises germanium if the strained relaxed buffer layer 7,8 is a III-V semiconductor material SRB layer or comprises a III-V semiconductor material wherein the SRB layer is a silicon germanium SRB layer 2,3.

According to preferred embodiments, wherein the strain relaxed buffer layer 2 is a silicon germanium SRB layer 2, the method further comprises providing a strained germanium layer 3 on top of the silicon germanium SRB layer before performing the shallow trench isolation process, and performing the shallow trench isolation process further comprises patterning the strained germanium layer 3.

According to preferred embodiments, wherein the strain relaxed buffer layer 7 is a III-V semiconductor material SRB layer, the method further comprises providing one or more quantum well layers 8 on top of the III-V semiconductor material SRB layer before performing the shallow trench isolation process, and performing the shallow trench isolation process further comprises patterning the one or more quantum well layers 8.

Method according to any of the previous layers, further comprising reducing the thickness of the isolation material, e.g. the silicon oxide, in between the protrusions, to thereby reveal an upper lateral portion or upper sidewall of the protrusions 5 or 2,3 , and providing a gate structure 6 on the protrusions 5 or 2,3.

In aspects of the present invention, the protrusions form active narrow structures having a width smaller than 20nm and are patterned and isolated in the SRB layer by using a silicon STI (Shallow Trench Isolation) process flow as it is known to the skilled person.

A STI process flow in the SRB can for instance comprise or consists of the following steps:
- perform lithography and etching processes to create trenches with areas in between the trenches;
- filling the created trenches with an isolation material such as for instance a silicon oxide;
- performing a planarization process as for instance a Chemical Mechanical Polishing (CMP) process for planarizing the surface, resulting in features in the SRB being separated by silicon oxide areas.

In order to ensure adhesion of the isolation material to the SRB in an STI process, deposition of a thin adhesion layer such as for instance silicon prior to filling the trenches with the isolation material may be required.

It can be noted that processing constraints are to be taken into account, such that the quality of the SRB channel material is not compromised during the STI processing.

According to preferred embodiments of the present invention, the SRB areas or protrusions defined in the STI oxide have dimensions which are smaller than 20nm and have a depth which is preferably larger than 40nm. This allows benefiting from an aspect ratio trapping (ART) effect during subsequent epitaxial growth of material of the active region or layer in a region B.

Afterwards, the method comprises partially or completely removing the narrow SRB areas/protrusions defined in the STI oxide, preferably up to a depth larger than 40nm, in a first region B, creating complementary trenches, and refilling the trenches by a semiconductor structure 5 or 2,3 constituting a second type of protrusion (e.g. corresponding to a FIN structure of a MOS device of opposite conductivity) by epitaxially growing a channel material (for instance a III-V material stack) having a lattice constant different from the lattice constant of silicon or the SRB material. The cavities can be overfilled or overgrown by the growing channel material over STI and the epitaxially grown material which overgrew the STI areas can then subsequently be removed, for instance by CMP. Alternatively, the trenches or cavities can be filled by the epitaxially grown material without overgrowing the STI area. Adjacent to the first region B, there is at least one second region A, wherein the original protrusions are not replaced by a new material.

The material of the semiconductor structure 5 or 2,3 / protrusion of the second type is preferably a crystalline material with a different lattice constant than the lattice constant of the silicon substrate 1 and the SRB layer 2,7. The depth and width of the trenches is such that defects generated in the epitaxially grown layer of the material of the semiconductor structure 5 or 2, 3 at the substrate portion at the bottom of the cavity which propagate in the 111 direction are trapped by the trench sidewalls. Temperature has to be controlled during the growth of the material of the semiconductor structure 5 or 2,3 as to not impact the quality of the channel material 3 during this processing.

Gate structures 6 can then be provided on the respective channel structures, according to processes known to the skilled person.

The skilled person will recognize that temperature constraints apply, as the quality of the channel materials during the above described processing should not be impacted.

It will be appreciated by the skilled person that the method and associated substrate of the first aspect of the present invention allow dual material channel integration on a silicon substrate. Hereby, the semiconductor structures of the second channel material, preferably of the FINFET type, can be provided essentially defect free, by using a hetero-epitaxial growth on the silicon substrate or the SRB layer needed for the first channel FINFET type. Both types of channel transistors can then be further integrated on the same wafer.

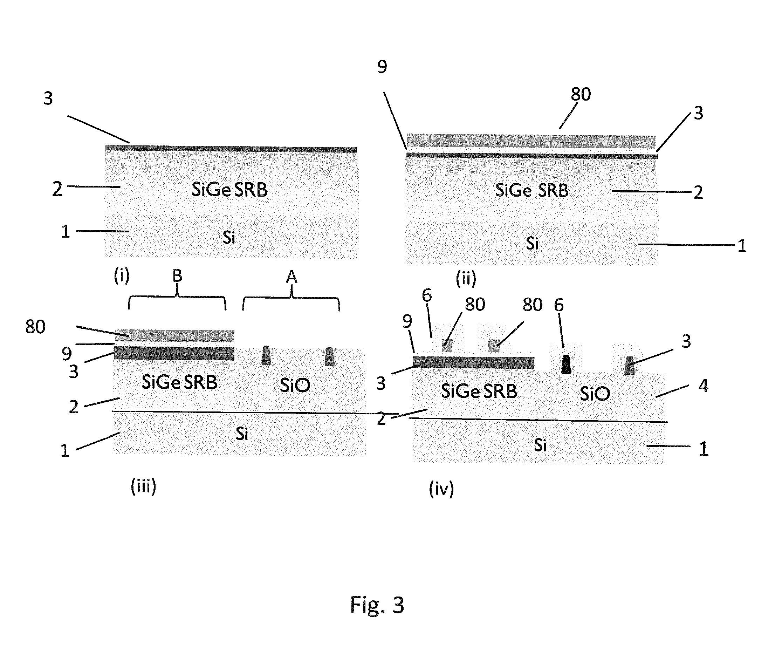

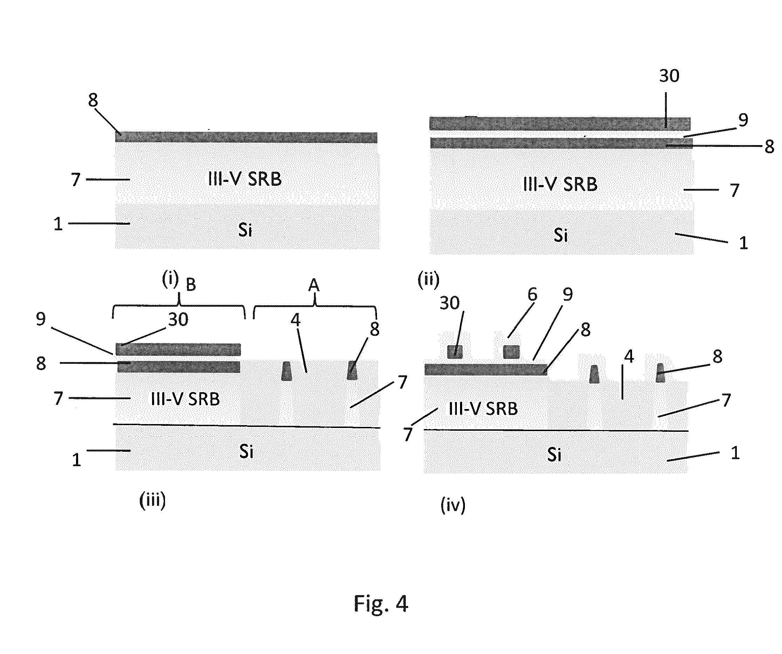

According to a **second aspect** of the present invention, illustrated in Figure 3 and 4, a method is disclosed for manufacturing a CMOS device, the CMOS device comprising transistor devices of different conductivity types, the respective transistor devices having channel materials which have different lattice constants, comprising:
- providing a silicon substrate;
- providing a layer stack on the substrate, the layer stack comprising a strain relaxed buffer layer and being selected as one of the set of a silicon germanium SRB layer 2, a combination of a silicon germanium SRB layer 2 and a strained germanium layer 3 on top, and a III-V semiconductor material SRB layer 7 comprising at least one upper quantum well layer 8;
- providing a dielectric layer 9 on top of the layer stack;
- providing a semiconductor layer on top of the dielectric layer, the semiconductor layer 30 comprising germanium when the layer stack is a III-V semiconductor SRB layer with one or more III-V quantum well layers on top, or the semiconductor layer 80 comprising a III-V semiconductor layer if the layer stack is a silicon germanium SRB layer or a silicon germanium SRB layer with a strained germanium layer on top;
- selectively removing the semiconductor layer 30,80 and the dielectric layer 9 in a first area of the substrate, to thereby expose the layer stack in the first area;
- performing a shallow trench isolation process to the layer stack in the first area, comprising patterning the layer stack into a set of protrusions 2,3 or 7,8, for instance extending from the substrate, and providing an isolation material, e.g. silicon oxide 4 and optional adhesion layer in between adjacent protrusions to electrically isolate them from each other, the protrusions and the isolation structures abutting on an upper common planar surface, and the protrusions corresponding to channel structures of transistors of a first conductivity type;
- patterning the semiconductor layer in a second area adjacent to the first area, thereby defining channel structures of transistor device of a second conductivity type.

In the first step of the processing flow, the second channel material is removed selectively towards the intermediate dielectric layer 9 or the SRB substrate layer in the area where the first channel material and its isolation are to be provided afterwards (called region A).

The intermediate dielectric layer can comprise or consist of silicon oxide, silicon nitride, a low-k material, aluminum oxide or any combination of these dielectrics.

In aspects of the present invention active narrow structures having a width smaller than 20nm are patterned and isolated in the SRB material in the region A by using a STI (Shallow Trench Isolation) process flow as it is known to the skilled person, compatible with the SRB material.

According to preferred embodiments of the present invention, the SRB areas or protrusions defined in the STI oxide have dimensions which are smaller than 20 nm and have a depth which is preferably larger than 20 nm. Preferably, temperature constraints are taken into account, such that the quality of the channel materials is not compromised during the STI processing. The temperature is therefore preferably kept below 700°C.

In a further step of fabricating a suitable dual channel structure for CMOS device fabrication, the remaining channel material 80,30 is subsequently patterned to provide the appropriate active structure, for instance FIN structure transistor device of the opposite type, in the region B for the targeted device fabrication using material 80,30 as channel or active layer material.

Gate structures 6 can then be provided on the respective channel structures, according to processes known to the skilled person.

The skilled person will recognize that temperature constraints apply, as the quality of the channel materials during the above described processing should not be impacted.

It will be appreciated by the skilled person that the method and associated substrate of the second aspect of the present invention allow dual material channel integration on a silicon substrate.

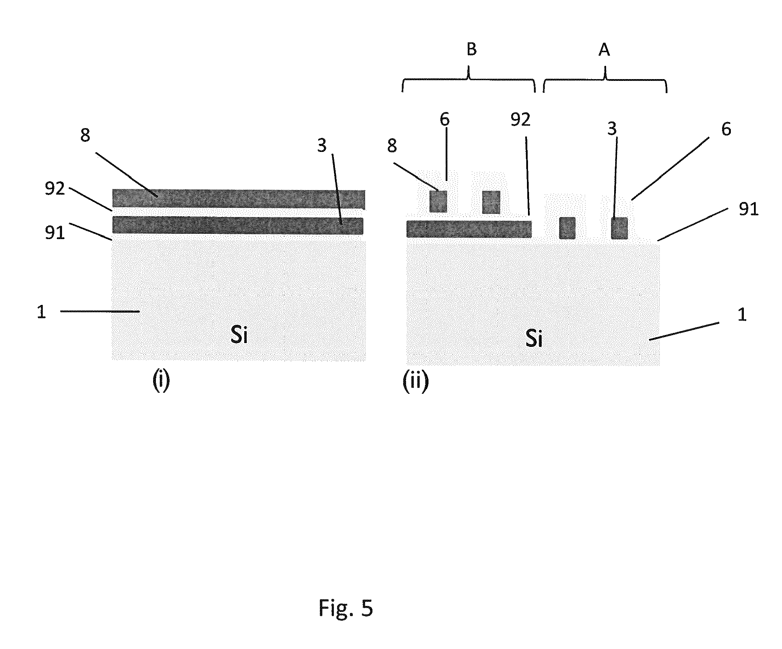

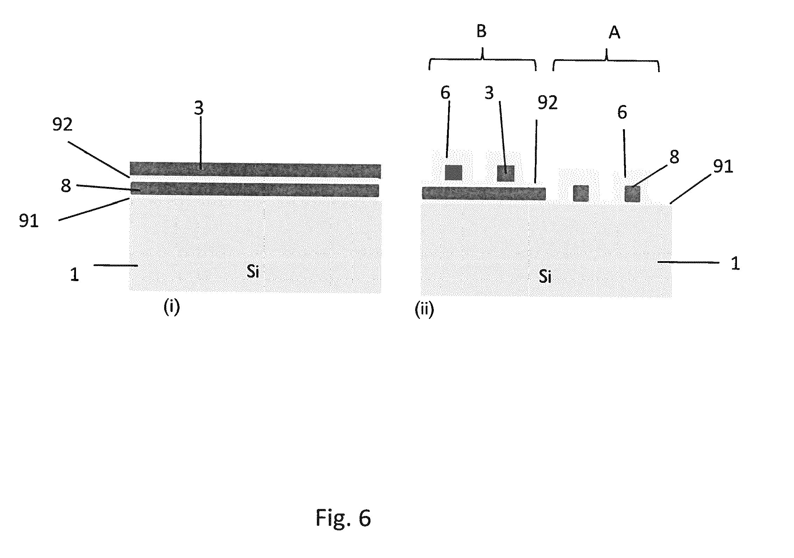

According to a **third aspect** of the present invention, illustrated in Figure 5 and 6, a method for manufacturing a CMOS device is disclosed, the CMOS device comprising transistor devices of different conductivity types, the respective transistor devices having channel materials which have different lattice constants, comprising:
- providing a silicon substrate 1;
- providing a first dielectric layer 91 on a main surface of the silicon substrate 1;
- providing a first semiconductor layer 3 or 8, the first semiconductor layer being selected from a set of a germanium layer 3 and a III-V semiconductor material layer stack 8, on top of the first dielectric layer 91 ;
- providing a second dielectric layer 92 on top of the first semiconductor layer;
- providing a second semiconductor layer 8 or 3 on top of the second dielectric layer, the second semiconductor layer being the other one of the set of a germanium layer and a III-V semiconductor material layer stack;
- selectively removing the second semiconductor layer and the second dielectric layer 92 in a first area of the substrate, to thereby expose the first semiconductor layer in the first area;
- patterning the exposed first semiconductor layer in the first area, thereby defining channel structures of transistor devices of a first conductivity type;
- patterning the second semiconductor layer in a second area adjacent to the first area, thereby defining channel structures of a transistor device of a second conductivity type.

In the first step of the processing flow, the second channel material or second semiconductor layer is patterned selectively towards the intermediate dielectric layer 92 or the first channel layer. In the area where the first channel material or first semiconductor material structures are to be provided afterwards (called region A), the second channel material is fully removed. In aspects of the present invention active narrow structures of the second channel material having a width smaller than 20nm are patterned in region B (area of devices with the second channel material).

In a further step of fabricating a suitable dual channel structure for CMOS device fabrication, the remaining intermediate dielectric layer 92 (if remaining after the first patterning step) is removed in region A and the first channel material which is thus exposed after patterning of the top layer is subsequently patterned selectively towards the bottom dielectric layer 91 to provide the appropriate active structure, for instance FIN structure transistor device of the first channel material. As such, the appropriate active structure, for instance FIN structure transistor device of the different channel materials are patterned on a common substrate 1. Gate structures can then be provided on the respective channel structures, according to processes known to the skilled person.

The first dielectric layer and the second dielectric layer can comprise or consist of silicon oxide, silicon nitride, a low-k material, aluminum oxide or any combination of these dielectrics.

The skilled person will recognize that temperature constraints apply, as the quality of the channel materials during the above described processing should not be impacted.

For the purpose of the present description, a quantum well layer or set of quantum well layers can for instance comprise or consist of germanium on Silicon Germanium or Germanium Tin for Germanium-containing structures and InₓAl1-xAs, InxGa1-xAs, InxGa1-xSb, AlxGa1-xSb, AlxGa1-xSb(As), InP or combinations thereof to create a heterostructure stack for a III-V semiconductor material or material stack.

It will be appreciated by the skilled person that the method and associated substrate of the third aspect of the present invention allow dual material channel integration on a silicon substrate.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B, and further the claim should be interpreted as including equivalents of those components.

## Claims

1. A method for manufacturing a CMOS device, said CMOS device comprising transistor devices of different conductivity types, said respective transistor devices having channel materials which have different lattice constants, comprising:
- providing a silicon substrate;
- providing a strain relaxed buffer layer on said substrate, said strain relaxed buffer layer selected as one of the set of a silicon germanium SRB layer, a combination of a silicon germanium SRB layer and a strained germanium layer, and a III-V semiconductor material SRB layer comprising at least one upper quantum well layer;
- performing a shallow trench isolation process to said strain relaxed buffer layer, comprising patterning said strain relaxed buffer layer into a set of protrusions and providing a an isolation material in between adjacent protrusions to electrically isolate them from each other, said protrusions and said isolation structures abutting on a common planar surface, said protrusions having a first conductivity type;
- removing an upper portion of at least one protrusion, thereby leaving a corresponding trench;
- growing a semiconductor material in said trench to thereby form a protrusion of a second conductivity type; wherein said semiconductor material comprises germanium if said strained relaxed buffer layer is a III-V semiconductor material SRB layer or comprises a III-V semiconductor material wherein said SRB layer is a silicon germanium SRB layer.

2. Method according to claim 1, wherein said strain relaxed buffer layer is a silicon germanium SRB layer, wherein the method further comprises providing a strained Germanium layer on top of said silicon germanium SRB layer before performing said shallow trench isolation process, and wherein performing said shallow trench isolation process further comprises patterning said strained germanium layer.

3. Method according to claim 1, wherein said strain relaxed buffer layer is a III-V semiconductor material SRB layer, wherein the method further comprises providing one or more quantum well layers on top of said III-V semiconductor material SRB layer before performing said shallow trench isolation process, and wherein performing said shallow trench isolation process further comprises patterning said one or more quantum well layers.

4. Method according to any of the previous layers, further comprising reducing the thickness of the isolation material in between said protrusions, to thereby reveal an upper lateral portion of said protrusions, and providing a gate structure on said protrusions.

5. A method for manufacturing a CMOS device, said CMOS device comprising transistor devices of different conductivity types, said respective transistor devices having channel materials which have different lattice constants, comprising:
- providing a silicon substrate;
- providing a layer stack on said substrate, said layer stack comprising a strain relaxed buffer layer and being selected as one of the set of a silicon germanium SRB layer, a combination of a silicon germanium SRB layer and a strained germanium layer, and a III-V semiconductor material SRB layer comprising at least one upper quantum well layer;
- providing a dielectric layer on top of said layer stack;
- providing a semiconductor layer on top of said dielectric layer, said semiconductor layer comprising germanium when said layer stack is a III-V semiconductor SRB layer with one or more III-V Quantum Well layers on top, or comprising a III-V semiconductor layer if the layer stack is a silicon germanium SRB layer or a silicon germanium SRB layer with a strained germanium layer on top;
- selectively removing said semiconductor layer and said dielectric layer in a first area of said substrate, to thereby expose the layer stack in said first area;
- performing a shallow trench isolation process to said layer stack in said first area, comprising patterning said layer stack into a set of protrusions and providing an isolation material in between adjacent protrusions to electrically isolate them from each other, said protrusions and said isolation structures abutting on an upper common planar surface, and said protrusions corresponding to channel structures of transistors of a first conductivity type;
- patterning said semiconductor layer in a second area adjacent to said first area, thereby defining channel structures of transistor device of a second conductivity type.

6. A method for manufacturing a CMOS device, said CMOS device comprising transistor devices of different conductivity types, said respective transistor devices having channel materials which have different lattice constants, comprising:
- providing a substrate;
- providing a first dielectric layer on a main surface of said silicon substrate;
- providing a first semiconductor layer, said first semiconductor layer being selected from a set of a germanium layer and a III-V semiconductor material layer stack, on top of said first dielectric layer;
- providing a second dielectric layer on top of said first semiconductor layer;
- providing a second semiconductor layer on top of said second dielectric layer, said second semiconductor layer being the other one of the set of a germanium layer and a III-V semiconductor material layer stack;
- selectively removing said second semiconductor layer and said second dielectric layer in a first area of said substrate, to thereby expose said first semiconductor layer in said first area;
- patterning said exposed first semiconductor layer in said first area, thereby defining channel structures of transistor devices of a first conductivity type;
- patterning said second semiconductor layer in a second area adjacent to said first area, thereby defining channel structures of transistor device of a second conductivity type.

7. Method according to claim 6, wherein said a III-V semiconductor material layer stack comprises InₓAl1-xAs, InxGa1-xAs, InxGa1-xSb, AlxGa1-xSb, AlxGa1-xSb(As), InP or any combinations thereof.

8. Method according to any of the previous claims 6 or 7, wherein said first dielectric layer comprises silicon oxide, silicon nitride, a low-k material, aluminum oxide or any combination of these dielectrics.

9. Method according to any of the claims 6 or 8, wherein said second dielectric comprises silicon oxide, silicon nitride, a low-k material, aluminum oxide or any combination of these dielectrics.

10. Method according to any of the claims 6 to 9, further comprising providing gate structures on said channel structures.
